# EUROPÄISCHE PATENTSCHRIFT

(11) **EP 3 673 551 B1**
(45) Veröffentlichungstag und Bekanntmachung des Hinweises auf die Patenterteilung: **25.09.2024**
(21) Anmeldenummer: 18758573.2
(22) Anmeldetag: 16.08.2018
(51) Int. Cl.: H02J 1/14, H03K 17/06

(54) **SPANNUNGSVERSORGUNGSSCHALTKREIS**
VOLTAGE SUPPLY CIRCUIT
CIRCUIT D'ALIMENTATION EN TENSION

(30) Priorität: 25.08.2017 DE 102017119487
(43) Veröffentlichungstag der Anmeldung: 01.07.2020
(73) Patentinhaber: Eaton Intelligent Power Limited, Dublin 4 (IE)
(72) Erfinder: FRÜCHT, Johannes, 59494 Soest-Ampen (DE)
(74) Vertreter: Novagraaf Group
(86) Internationale Anmeldenummer: PCT/EP2018/072223
(87) Internationale Veröffentlichungsnummer: WO 2019/038176

(56) Entgegenhaltungen:
- EP-A2- 2 458 727
- US-B1- 6 256 182

## Beschreibung

Die Erfindung betrifft einen Spannungsversorgungsschaltkreis zur Versorgung zumindest eines und vorzugsweise mehrerer Verbraucher. Ein solcher Verbraucher kann beispielsweise eine Steuereinrichtung, ein Batterieladegerät, ein elektronisches Vorschaltgerät oder dergleichen sein.

Aus der Praxis sind Spannungsversorgungsschaltkreise zur Versorgung solcher Verbraucher bekannt, wobei wenigstens einer der Verbraucher ein- und ausschaltbar ist und wobei der Spannungsversorgungsschaltkreis einen Spannungsanschluss für eine Netzspannung aufweist. Dem Spannungsanschluss sind eine Filtereinrichtung und ein Gleichrichter nachgeordnet. Die verschiedenen Verbraucher oder Schaltungen werden mit der gleichgerichteten Spannung versorgt und sind über Entkopplungsdioden entkoppelt, wobei über die Entkopplungsdioden die jeweiligen Verbraucher mit der gleichgerichteten Spannung versorgbar sind.

US 6,256,182 B1 offenbart einen Schaltkreis, der eine Funktion zum Entfernen einer Restspannung ausführt. Der Schaltkreis umfasst einen ersten Schalter mit einem ersten Anschluss, der mit der ersten Stromquelle verbunden ist, einem zweiten Anschluss, der mit der Lastkomponente verbunden ist, und einem Steueranschluss, dem ein erstes Steuersignal zum Steuern des ersten Schalters zugeführt wird; einen zweiten Schalter mit einem ersten Anschluss, der mit dem Steueranschluss des ersten Schalters verbunden ist, einem zweiten Anschluss, der mit der zweiten Stromquelle verbunden ist, und einem Steueranschluss, dem ein zweites Steuersignal zum Steuern des zweiten Schalters zugeführt wird; und ein Rückstrom-Verhinderungselement, das zwischen der Lastkomponente und dem ersten Anschluss des zweiten Schalters angeschlossen ist. Ein Fehlerzustand des zweiten Schalters wird erkannt und ein unnötiger Stromfluss vom zweiten Anschluss des ersten Schalters zur zweiten Stromquelle wird verhindert.

EP 2 458 727 A2 offenbart ein Gate-Treiber-Stromversorgungssystem und eine Wechselrichter-Steuerschaltung, die für ein Wechselrichtersystem mit mehreren Leistungstransistoren verwendet werden, die einer Schaltsteuerung unterliegen, um elektrische Energie zur Steuerung eines Gate-Treiberschaltkreises für jeden der Leistungstransistoren zu liefern.Die Versorgungsspannung kann länderspezifische Spannungen und Frequenzen aufweisen, wie beispielsweise 110 V, 230 V, 60 Hz, 50 Hz und dergleichen. Die Filtereinrichtung verhindert ungewollte elektrische oder elektromagnetische Effekte, durch die die Verbraucher oder auch andere Geräte gestört werden könnten. Außerdem kann die Filtereinrichtung natürliche oder technische externe Störquellen herausfiltern, wobei dies sowohl für dynamische als auch statische Störungen gilt.

Der Erfindung liegt die Aufgabe zugrunde, eine Spannungsversorgungsschaltung der eingangs beschriebenen Art dahingehend zu verbessern, diese bei einfachem und platzsparendem Aufbau die entsprechenden Verbraucher in Form von elektronischen Vorschaltgeräten, Steuereinrichtungen, Batterieladegeräten oder dergleichen nicht nur zur Spannungsversorgung mit höheren Spannungen, sondern auch zum Schalten einsetzen zu können.

Diese Aufgabe wird durch die Merkmale des Patentanspruchs 1 gelöst.

Der Erfindungsgegenstand zeichnet sich insbesondere dadurch aus, dass zumindest einem ersten Verbraucher ein Sperrwandler zugeordnet ist, welcher beim Schalten eines Sperrwandler-Transformators eine Schaltspannung höher als die Versorgungsspannung erzeugt. Zusätzlich wird diese Schaltspannung über zumindest einen einem zweiten Verbraucher vorgeschalteten N-MOSFET (n-Kanal Metall-Oxid-Halbleiter-Feldeffekttransistor) zu dessen Ein-/Ausschalten zugeführt.

Aus der Praxis sind schon Vorschaltgeräte mit einem p-Kanal-MOSFET bekannt. Allerdings ist ein solcher p-Kanal-MOSFET bei einer gleichgerichteten Versorgungsspannung allgemein teurer als ein entsprechender n-Kanal-MOSFET für die gleiche Spannung oder den gleichen Strom. Weiterhin ist bei einem p-Kanal-MOSFET der Drain-Source-Widerstand im eingeschalteten Zustand erheblich höher als bei einem n-Kanal-MOSFET, so dass die Verlustwärme entsprechend hoch ist. Würde beispielsweise ein p-Kanal-MOSFET mit ungefähr gleichem Drain-Source-Widerstand wie bei einem n-Kanal-MOSFET verwendet, so müsste dieser erheblich größer im Aufbau sein, um den Anforderungen an die Wärmeabfuhr zu genügen. Aus der Praxis zeigt sich, dass beispielsweise ein p-Kanal-MOSFET ungefähr viermal so viel Raum einnimmt, wie ein äquivalenter n-Kanal-MOSFET.

Dies ist erfindungsgemäß nicht mehr nötig, da ein entsprechender n-Kanal-MOSFET durch die Versorgung mit einer Schaltspannung vom Sperrwandler des ersten Verbrauchers erfolgt.

Diese Anordnung ist für alle Netzspannungen mit länderspezifischen Spannungswerten oder -frequenzen einsetzbar.

Um in einfacher Weise in der Filtereinrichtung sich störende Spannungen zu verhindern, kann die Filtereinrichtung einen Entstörkondensator, insbesondere in Form eines Y-Kondensators, aufweisen. Entsprechende Funk-Endstörkondensatoren sind je nach Anforderungsprofil in den Klassen X und Y definiert. Klasse-Y-Kondensatoren nach IEC 60384-1 sind Kondensatoren, die zwischen Phase- respektive Neutralleiter und berührbarem, schutzgeerdetem Apparategehäuse angeschlossen werden und damit eine Basisisolierung überbrücken. Der Neutralleiter entspricht dabei dem Schutzleiter PE von beispielsweise einem industriell genutzten Steckverbinder zum Anschluss der Netzspannung an den Spannungsversorgungsschaltkreis.

Ein entsprechender Sperrwandler (Hoch-Tief-Setzsteller) oder Flyback-Converter, ist eine spezifische Bauform von Gleichspannungswandlern. Er dient zur Übertragung elektrischer Energie zwischen einer Eingangs- und einer Ausgangsseite galvanisch getrennter Gleichspannungen. Gemäß der vorliegenden Erfindungen ist eine entsprechende Schalteinrichtung des Sperrwandlers ein Bauteil aus der Gruppe von Bipolartransistor, MOSFET oder Sperrwandler-IC (integrierte Schaltung). Der Sperrwandler weist eine entsprechende Sperrphase und eine entsprechende Leitphase auf.

In diesem Zusammenhang ist es inbesondere günstig, wenn beim Ausschalten der Schalteinheit ein Polaritätswechsel eines Sperrwandlertransformators mit einem Spannungsanstieg am Bauteilanschluss verursacht wird. Die Spannung kann bei üblichen Komponenten mehrere hundert Volt und beispielsweise 600 V, 700 V oder 800 V betragen.

Durch diese Spannung wird erfindungsgemäß eine erforderliche Gatespannung für den N-MOSFET, der dem zweiten oder auch weiteren Verbrauchern vorgeschaltet ist, zur Verfügung gestellt. Der Bauteilanschluss kann bei einem Transistor als entsprechendem Bauteil der Drain-Anschluss sein. Bei einem Bipolartransistor wäre der Bauteilanschluss der Kollektor-Anschluss.

Um ggf. den Spannungswert zu reduzieren, kann der Bauteilanschluss bzw. der Drain-Anschluss des Sperrwandler-Transistors mit einem Snubber-Schaltkreis zur Spannungsverminderung verbunden sein. Dadurch werden zu hohe Spannungen verhindert und der entsprechende Spannungsanstieg gegenüber der Versorgungsspannung wird dann zum Einschalten des N-MOSFET im Pluskreis verwendet.

In diesem Zusammenhang kann es weiterhin als vorteilhaft betrachtet werden, wenn der Snubber-Schaltkreis im Sperrwandler integriert ist und durch Zufuhr der entrsprechenden Spannung zum N-MOSFET mit einem Gate-Anschluss von diesem zu dessen Einschalten verschaltet ist.

Der entsprechende dem N-MOSFET zugeordnete Verbraucher kann beispielsweise ein elektronisches Vorschaltgerät sein.

Der Snubber-Schaltkreis kann beispielsweise zwei parallel geschaltete Widerstände mit einem mit den Widerständen in Serie geschalteten Kondesator umfassen.

Das heißt, die entsprechende Gate-Spannung für den N-MOSFET wird durch den Sperrwandler bzw. dessen Schalteinheit in Zusammenhang mit dem Sperrwandlertransformator erzeugt und dann zum Einschalten des N-MOSFET verwendet.

Um ggf. einen entsprechenden Gate-Strom zu begrenzen, kann dem Gate-Anschluss ein Begrenzungswiderstand vorgeordnet sein. Das heißt, dieser ist zwischen Snubber-Schaltkreis und Gate-Anschluss angeordnet. Es kann sich weiterhin als vorteilhaft erweisen, wenn die entsprechende Spannung am Gate von einer Drain-Spannung der Schalteinheit des Sperrwandlers entkoppelt ist, wozu beispielsweise eine Entkopplungsdiode zwischen Begrenzungswiderstand und Gate-Anschluss verschaltet ist.

Um ausreichend Energie zum Einschalten des N-MOSFET in einfacher Weise bereitsstellen zu können, kann außerdem zumindest ein Energiespeicherkondensator zwischen einem Source-Anschluss und dem Gate-Anschluss des N-MOSFET verschaltet sein.

Um eine maximale Gate-Spannung nicht zu überschreiten, kann eine Begrenzungsdiode zwischen Source- und Drain-Anschluss parallel zum Energiespeicherkondensator verschaltet sein.

Um den N-MOSFET wieder ausschalten zu können, kann eine Kurzschlusseinrichtung zwischen Gate- und Source-Anschluss vorgesehen sein. Ein Beispiel für eine solche Kurzschlusseinrichtung ist ein Optokoppler, der durch eine IC-Schaltung oder einen Micro-Controller schaltbar ist. Die entsprechende IC-Schaltung kann außerdem unterschiedliche Zustände des Vorschaltgerätes steuern, wie beispielsweise eine Notbeleuchtung oder dergleichen.

Um auch beim Ausschalten den Strom entsprechend begrenzen zu können, kann ein Strombegrenzungswiderstand zwischen Gate-Anschluss und Energiespeicherkondensator verschaltet sein.

Es besteht natürlich die Möglichkeit, dass weitere Verbraucher durch dieses Schalten mittels N-MOSFET und zugeordneten Bauteilen ebenfalls geschaltet werden. In diesem Fall wären mehrere Verbraucher entsprechend mit dem N-MOSFET verschaltet. Ebenso ist es denkbar, dass jeder weitere Verbraucher einen entsprechenden N-MOSFET und eine Kurzschlusseinrichtung wie einen Optokoppler oder dergleichen aufweisen. Dadurch ist jeder Verbraucher einzeln schaltbar, wobei dies beispielsweise auch über einen gemeinsamen oder auch eine Anzahl von Micro-Controllern oder IC-Schaltungen erfolgen kann.

Weiterhin als günstig kann betrachtet werden, wenn dem Sperrwandler eine Einschalt-Strombegrenzungseinrichtung zur Begrenzung des Einschaltstroms zugeordnet ist oder dieser eine solche Einrichtung aufweist, Im einfachsten Fall ist dieser aus einem Kondensator und einem Widerstand gebildet.

Im Folgenden wird ein vorteilhaftes Ausführungsbeispiel anhand der in der Zeichnung beigefügten Figur weiter erläutert.

Es zeigt:

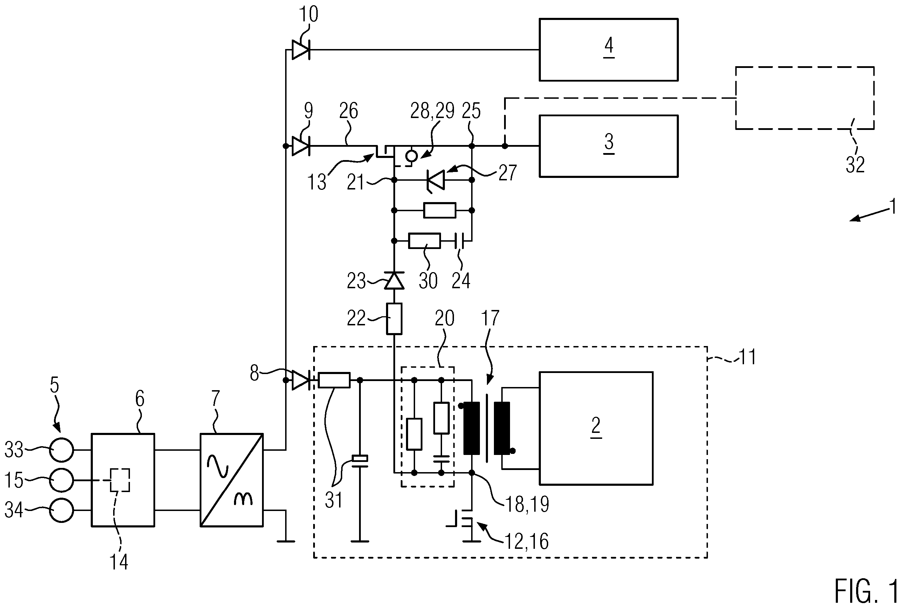

- Figur 1: eine Prinzipdarstellung eines erfindungsgemäßen Spannungsversorg-ungsschaltkreises mit drei Verbrauchern.

In Fig. 1 ist ein Ausführungsbeispiel eines erfindungsgemäßen Spannungsversorgungsschaltkreises 1 zur Spannungsversorgung und zum Schalten entsprechender Verbraucher 2, 3, 4 und 32 dargestellt. Der Spannungsversorgungsschaltkreis 1 weist einen Spannungsanschluss 5 für eine Versorgungsspannung auf, die bei dem dargestellten Ausführungsbeispiel Anschlüsse für Schutzleiter 15, Außenleiter 33 bzw. Neutralleiter 34 aufweist. Über den entsprechenden Spannungsanschluss 5 wird die Versorgungsspannung bzw. Netzspannung einer Filtereinrichtung 6 zugeführt. Ein Teil der Filtereinrichtung kann ein Entstörkondensator und insbesondere Y-Kondensator 14 sein, der sich störende Spannungen zum Schutzleiter 15 abgibt.

Anschließend an die Filtereinrichtung ist ein Gleichrichter 7 verschaltet. In diesem wird die Wechselspannung in eine Gleichspannung umgewandelt und anschließend an entsprechende Zweige des Spannungsversorgungsschaltkreises zu unterschiedlichen Verbrauchern 2, 3, 4 oder auch 32 übermittelt. Zwischen Gleichrichter und den verschiedenen Zweigen ist jeweils eine Entkopplungsdiode 8,9 bzw. 10 angeordnet.

Im ersten Zweig, siehe Versorgung über die Entkopplungsdiode 8, ist ein Sperrwandler 11 angeordnet, der einen Verbraucher 2 in Form einer Steuerung, eines Batterieladegeräts oder dergleichen versorgt. Der Sperrwandler bildet im Wesentlichen ein Schaltnetzteil für den entsprechenden Verbraucher und weist als Schalteinrichtung 12 ein Bauteil 16 in Form eines Bipolartransistors, eines MOSFETs oder einer IC-Schaltung für spezifische Anwendungen des Sperrwandlers auf. Der Sperrwandler wird durch die Schalteinrichtung 12 entsprechend geschaltet, wobei bei einem Ausschalten der Schalteinrichtung 12 eine Polarität eines entsprechenden Sperrwandlertransformators 17 sich ändert und dadurch die Spannung am Drain-Anschluss 19 der Schalteinrichtung 12 in Form eines Transistors ansteigt. Diese hohe Spannung wird durch einen nachgeordneten Snubber-Schaltkreis 20 reduziert.

Ein solcher Snubber-Schaltkreis kann auch als Dämpfungseinrichtung bezeichnet werden, da durch eine solche elektrische Schaltung störende Hochfrequenzen oder Spannungsspitzen neutralisiert werden. Diese treten meist beim Schalten induktiver Lasten auf, wenn der Stromfluss abrupt unterbrochen wird.

In dem dargestellten Beispiel ist der Snubber-Schaltkreis 20 ein RC-Snubberglied aus einer Reihenschaltung eines Kondensators mit einem Widerstand und einem zu diesen beiden parallel geschalteten weiteren Widerstand.

Durch den Snubber-Schaltkreis 20 wird die hohe Spannung von der Schalteinrichtung 12 reduziert auf einen Wert, der allerdings noch höher als der entsprechende Spannungswert der Netzspannung ist. Beispielsweise kann die Spannung noch einige hundert Volt, 600 V, 700 V oder 800 V betragen.

Die entsprechende Spannung wird über den Snubber-Schaltkreis 20 einem N-MOSFET 13 bei einem weiteren zweiten Verbraucher 3 zugeführt. Dieser Verbraucher 3 ist über die Entkopplungsdiode 9 mit dem Gleichrichter 7 verbunden. Zwischen Entkopplungsdiode 9 und Verbraucher 3 ist der N-MOSFET 13 angeordnet. Ein entsprechender Drain-Anschluss 26 ist der Entkopplungsdiode 9, ein entsprechender Source-Anschluss 25 dem Verbraucher 3 und ein Gate-Anschluss 21 dem Snubber-Schaltkreis 20 zugeordnet. Der zweite Verbraucher 3 ist beispielsweise ein elektronisches Vorschaltgerät, das durch den N-MOSFET 13 einschaltbar ist. Die entsprechende Gate-Spannung wird vom Sperrwandler 11 über den Snubber-Schaltkreis 20 dem Gate-Anschluss 21 zugeführt.

Um einen entsprechenden Gate-Strom zu begrenzen, ist ein Begrenzungswiderstand 22 dem Gate-Anschluss 10 vorgeordnet sowie ebenfalls eine Entkopplungsdiode 23, die eine Entkopplung einer entsprechenden Spannung von der Drain-Spannung ermöglicht.

Es ist weiterhin ein Energie-Speicherkondensator 24 vorgesehen, der ausreichend Energie zum Einschalten des N-MOSFET 13 speichert. Weiterhin wird mittels einer Begrenzungsdiode 27 eine maximale GateSpannung festgelegt.

In Reihe mit dem Energie-Speicherkondensator 24 ist weiterhin ein Strombegrenzungswiderstand 30 verschaltet, der einen entsprechenden Strom begrenzt.

Um den N-MOSFET wieder ausschalten zu können, ist eine Kurzschlusseinrichtung 28 zwischen Gate-Anschluss 21 und Source-Anschluss 25 des N-MOSFET 13 vorgesehen. Diese kann beispielsweise ein Optokoppler sein, der durch eine IC-Schaltung geschaltet wird. Kurzschlusseinrichtung 28 und Optokoppler 29 sind nur prinzipiell in Fig. 1 dargestellt.

Bezüglich der IC-Schaltung sei noch angemerkt, dass diese nicht nur den Optokoppler, sondern ggf. auch unterschiedliche Zustände des Vorschaltgerätes schalten kann, wie beispielsweise eine Notbeleuchtung oder dergleichen. Für diesen Fall ist insbesondere der Strombegrenzungswiderstand 30 vorgesehen, der auftretende Ströme begrenzt.

Erfindungsgemäß besteht die Möglichkeit, dass nicht nur ein Verbraucher 3 wie vorangehend beschrieben geschaltet wird, sondern dass noch ein weiterer Verbraucher 32 ebenfalls mit dem N-MOSFET 13 verschaltet ist. Außerdem besteht die Möglichkeit, dass auch der Verbraucher 4 entsprechend geschaltet wird oder aber selbst in seinem Zweig einen entsprechenden N-MOSFET mit den weiteren zugehörigen Bauteilen aufweist, siehe Begrenzungswiderstand 22, Entkopplungsdiode 23, Energie-Speicherkondensator 24 oder Begrenzungsdiode 27 sowie Kurzschlusseinrichtung 28.

Es besteht in diesem Zusammenhang die Möglichkeit, dass alle Optokoppler beispielsweise durch eine IC-Schaltung oder auch durch separate IC-Schaltungen oder einen Micro-Controller gesteuert werden.

Um bei dem Sperrwandler 11 beim Einschalten der Netzspannung zu hohe Ströme zu verhindern, kann diesem noch eine Einschaltstrom-Begrenzungseinrichtung 31 zugeordnet oder in diesem enthalten sein. Diese weist vorzugsweise einen Widerstand und einen Kondensator auf.

Erfindungsgemäß ergibt sich ein Spannungsversorgungsschaltkreis, der auch bei hohen Spannungen wenig Platzbedarf aufweist und sicher und schnell zur Spannungsversorgung und zum Schalten entsprechender Verbraucher eingesetzt werden kann. Einem der Verbraucher ist dabei ein Sperrwandler zugeordnet, von welchem eine Spannung höher als die Netzspannung zum Schalten eines N-MOSFET eines weiteren Verbrauchers verwendet wird.

## Patentansprüche

1. Spannungsversorgungsschaltkreis (1) zur Versorgung von zumindest einem ersten Verbraucher (2) und einem zweiten Verbraucher (3),
wobei der Spannungsversorgungsschaltkreis (1), Entkopplungsdioden (8, 9), einen Sperrwandler (11), einen N-MOSFET (13), einen Spannungsanschluss (5) für eine Netzspannung, eine Filtereinrichtung (6) und einen Gleichrichter (7) aufweist,
wobei der zweite Verbraucher (3) mittels des N-MOSFET (13) ein- und ausschaltbar ist,
wobei dem Spannungsanschluss (5) die Filtereinrichtung (6) und der Gleichrichter (7) nachgeordnet sind, um eine gleichgerichtete Spannung zu erzeugen,
wobei über die Entkopplungsdioden (8, 9) die jeweiligen Verbraucher (2, 3) mit der gleichgerichteten Spannung versorgbar sind,
wobei dem ersten Verbraucher (2) der Sperrwandler (11) zugeordnet ist, wobei der Sperrwandler (11) eine Schalteinrichtung (12) und einen Sperrwandler-Transformator (17) aufweist, und wobei der Sperrwandler (11) mittels der Schalteinrichtung (12), insbesondere beim Schalten des Sperrwandler-Transformators (17), eine Schaltspannung höher als die gleichgerichtete Spannung erzeugt, und
wobei die Schaltspannung dem N-MOSFET (13) zum Ein-/Ausschalten des zweiten Verbrauchers (3) zuführbar ist.

2. Spannungsversorgungsschaltkreis nach Anspruch 1, wobei
ein nicht schaltbarer Verbraucher (4) über eine weitere Entkopplungsdiode (10) angeschlossen ist, oder
die Filtereinrichtung (6) zumindest einen Kondensator (14), insbesondere Y-Kondensator, als Endstörkondensator aufweist, welcher vorzugsweise mit einem Schutzleiter (15) des Spannungsanschlusses (5) verbunden ist, oder
die Schalteinrichtung (12) des Sperrwandlers (11) ein Bauteil (16) aus der Gruppe von Bipolartransistor, N-MOSFET oder Sperrwandler-IC ist, und
wobei der Sperrwandler (11) optional eine Einschaltstrombegrenzungseinrichtung (31) zur Begrenzung eines Einschaltstromes aufweist.

3. Spannungsversorgungsschaltkreis nach einem der vorangehenden Ansprüche, wobei bei Ausschalten der Schalteinrichtung (12) ein Polaritätswechsel eines Sperrwandlertransformators mit einem Spannungsanstieg an einem Bauteilanschluss (18) verursacht ist.

4. Spannungsversorgungsschaltkreis nach Anspruch 3, wobei der Bauteilanschluss (18) bei einem Transistor als Bauteil (16) insbesondere der Drain-Anschluss (19) ist.

5. Spannungsversorgungsschaltkreis nach Anspruch 4, **dadurch gekennzeichnet, dass** der Drain-Anschluss (19) mit einem Snubber-Schaltkreis (20) zur Spannungsverminderung verbunden ist.

6. Spannungsversorgungsschaltkreis nach Anspruch 5, wobei der Snubber-Schaltkreis (20) mit einem Gate-Anschluss (21) des N-MOSFET (13) zu dessen Einschalten verschaltet ist.

7. Spannungsversorgungsschaltkreis nach Anspruch 5 oder 6, wobei der Snubber-Schaltkreis (20) im Sperrwandler (11) integriert ist.

8. Spannungsversorgungsschaltkreis nach Anspruch 6 oder 7, **dadurch gekennzeichnet, dass** dem Gate-Anschluss (21) ein Begrenzungswiderstand (22) zur Begrenzung eines Gate-Stromes vorgeordnet ist.

9. Spannungsversorgungsschaltkreis nach Anspruch 8, **dadurch gekennzeichnet, dass** eine Entkopplungsdiode (23) zwischen dem Begrenzungswiderstand (22) und dem Gate-Anschluss (21) verschaltet ist.

10. Spannungsversorgungsschaltkreis nach einem der vorangehenden Ansprüche 6 bis 9, **dadurch gekennzeichnet, dass** zumindest ein Energiespeicherkondensator (24) zwischen einem Source-Anschluss (25) und dem Gate-Anschluss (21) des N-MOSFETs (13) verschaltet ist.

11. Spannungsversorgungsschaltkreis nach Anspruch 10, **dadurch gekennzeichnet, dass**
eine Begrenzungsdiode (27) zwischen dem Source-Anschluss (25) und dem Gate-Anschluss (21) des N-MOSFET (13) parallel zum Energiespeicherkondensator (24) verschaltet ist, oder
eine Kurzschlusseinrichtung (28) zum Ausschalten des N-MOSFET (13) zwischen dem Source-Anschluss (25) und dem Gate--Anschluss (21) verschaltet ist.

12. Spannungsversorgungsschaltkreis nach Anspruch 11, **dadurch gekennzeichnet, dass** die Kurzschlusseinrichtung (28) ein insbesondere durch eine IC-Schaltung oder einen Micro-Controller schaltbarer Optokoppler (29) ist.

13. Spannungsversorgungsschaltkreis nach Anspruch 12, **dadurch gekennzeichnet, dass** durch die IC-Schaltung unterschiedliche Zustände des zweiten Verbrauchers (3) schaltbar sind.

14. Spannungsversorgungsschaltkreis nach einem der vorangehenden Ansprüche, **dadurch gekennzeichnet, dass** ein Strombegrenzungswiderstand (30) zwischen dem Gate-Anschluss (21) und dem Energiespeicherkondensator (24) verschaltet ist.

15. Spannungsversorgungsschaltkreis nach einem der vorangehenden Ansprüche, **dadurch gekennzeichnet, dass** zumindest ein weiterer Verbraucher (32) mit dem N-MOSFET (13) zum Schalten verbunden ist, wobei optional jedem der weiteren Verbraucher (32) ein N-MOSFET (13) und ein Optokoppler (29) zugeordnet ist.

## Claims

1. Voltage supply circuit (1) for supplying at least a first consumer (2) and a second consumer (3),
wherein the voltage supply circuit (1) comprises decoupling diodes (8, 9), a flyback converter (11), an N-MOSFET (13), a voltage connection (5) for a mains voltage, a filter device (6) and a rectifier (7),
wherein the second consumer (3) can be switched on and off by means of the N-MOSFET (13),
wherein the filter device (6) and the rectifier (7) are arranged downstream of the voltage connection (5) in order to generate a rectified voltage,
wherein the respective consumers (2, 3) can be supplied with the rectified voltage via the decoupling diodes (8, 9),
wherein the flyback converter (11) is assigned to the first consumer (2), wherein the flyback converter (11) comprises a switching device (12) and a flyback converter transformer (17), and wherein the flyback converter (11) generates a switching voltage higher than the rectified voltage by means of the switching device (12), in particular when the flyback converter transformer (17) is switched, and
wherein the switching voltage can be supplied to the N-MOSFET (13) for switching the second consumer (3) on/off.

2. Voltage supply circuit according to claim 1, wherein
a non-switchable consumer (4) is connected via a further decoupling diode (10), or
the filter device (6) comprises at least one capacitor (14), in particular a Y capacitor, as an end interference capacitor, which is preferably connected to a protective conductor (15) of the voltage connection (5); or
the switching device (12) of the flyback converter (11) is a component (16) from the group consisting of bipolar transistor, N-MOSFET or flyback converter IC; and
wherein the flyback converter (11) optionally comprises an inrush current limiting device (31) for limiting an inrush current.

3. Voltage supply circuit according to any of the preceding claims, wherein a polarity change of a flyback converter transformer with a voltage rise at a component connection (18) is caused when the switching device (12) is switched off.

4. Voltage supply circuit according to claim 3, wherein the component connection (18) is, in particular, the drain connection (19) in the case of a transistor as a component (16).

5. Voltage supply circuit according to claim 4, **characterized in that** the drain connection (19) is connected to a snubber circuit (20) for voltage reduction.

6. Voltage supply circuit according to claim 5, wherein the snubber circuit (20) is connected to a gate connection (21) of the N-MOSFET (13) for switching on same.

7. Voltage supply circuit according to either claim 5 or claim 6, wherein the snubber circuit (20) is integrated into the flyback converter (11).

8. Voltage supply circuit according to either claim 6 or claim 7, **characterized in that** a limiting resistor (22) for limiting a gate current is arranged upstream of the gate connection (21).

9. Voltage supply circuit according to claim 8, **characterized in that** a decoupling diode (23) is connected between the limiting resistor (22) and the gate connection (21).

10. Voltage supply circuit according to any of the preceding claims 6 to 9, **characterized in that** at least one energy storage capacitor (24) is connected between a source connection (25) and the gate connection (21) of the N-MOSFET (13).

11. Voltage supply circuit according to claim 10, **characterized in that**
a limiting diode (27) is connected between the source connection (25) and the gate connection (21) of the N-MOSFET (13), in parallel with the energy storage capacitor (24), or
a short-circuit device (28) for switching off the N-MOSFET (13) is connected between the source connection (25) and the gate connection (21).

12. Voltage supply circuit according to claim 11, **characterized in that** the short-circuit device (28) is an optocoupler (29) which can be switched in particular by an IC circuit or a microcontroller.

13. Voltage supply circuit according to claim 12, **characterized in that** different states of the second consumer (3) can be switched by the IC circuit.

14. Voltage supply circuit according to any of the preceding claims, **characterized in that** a current-limiting resistor (30) is connected between the gate connection (21) and the energy storage capacitor (24).

15. Voltage supply circuit according to any of the preceding claims, **characterized in that** at least one further consumer (32) is connected to the N-MOSFET (13) for switching, an N-MOSFET (13) and an optocoupler (29) optionally being assigned to each of the further consumers (32).

## Revendications

1. Circuit d'alimentation en tension (1) permettant d'alimenter au moins un premier consommateur (2) et un second consommateur (3),
dans lequel le circuit d'alimentation en tension (1) présente des diodes de découplage (8, 9), un convertisseur indirect (11), un MOSFET à canal N (13), une borne de tension (5) pour une tension de réseau, un dispositif filtrant (6) et un redresseur (7),
dans lequel le second consommateur (3) peut être mis en marche et mis à l'arrêt à l'aide du MOSFET à canal N (13),
dans lequel le dispositif filtrant (6) et le redresseur (7) sont disposés en aval de la borne de tension (5) pour générer une tension redressée,
dans lequel les consommateurs respectifs (2, 3) peuvent être alimentés par la tension redressée par l'intermédiaire des diodes de découplage (8, 9),
dans lequel le convertisseur indirect (11) est associé au premier consommateur (2), dans lequel le convertisseur indirect (11) présente un dispositif de commutation (12) et un transformateur de convertisseur indirect (17), et dans lequel le convertisseur indirect (11) génère une tension de commutation supérieure à la tension redressée à l'aide du dispositif de commutation (12), en particulier lors de la commutation du transformateur de convertisseur indirect (17), et
dans lequel la tension de commutation peut être appliquée au MOSFET à canal N (13) pour la mise en marche/la mise à l'arrêt du second consommateur (3).

2. Circuit d'alimentation en tension selon la revendication 1, dans lequel
un consommateur non commutable (4) est branché par l'intermédiaire d'une diode de découplage supplémentaire (10), ou
le dispositif filtrant (6) présente au moins un condensateur (14), en particulier un condensateur Y, en tant que condensateur antiparasite, lequel est relié de préférence à un conducteur de protection (15) de la borne de tension (5), ou
le dispositif de commutation (12) du convertisseur indirect (11) est un composant (16) du groupe constitué par un transistor bipolaire, un MOSFET à canal N ou un circuit intégré de convertisseur indirect, et
dans lequel le convertisseur indirect (11) présente éventuellement un dispositif de limitation de courant de mise en marche (31) permettant de limiter un courant de mise en marche.

3. Circuit d'alimentation en tension selon l'une des revendications précédentes, dans lequel, lors de la mise à l'arrêt du dispositif de commutation (12), un changement de polarité d'un transformateur de convertisseur indirect est provoqué par une augmentation de tension au niveau d'une borne de composant (18).

4. Circuit d'alimentation en tension selon la revendication 3, dans lequel la borne de composant (18) dans un transistor en tant que composant (16) est en particulier la borne de drain (19).

5. Circuit d'alimentation en tension selon la revendication 4,
**caractérisé en ce que** la borne de drain (19) est reliée à un circuit amortisseur (20) permettant de réduire la tension.

6. Circuit d'alimentation en tension selon la revendication 5, dans lequel le circuit amortisseur (20) est connecté à une borne de grille (21) du MOSFET à canal N (13) pour la mise en marche de celui-ci.

7. Circuit d'alimentation en tension selon la revendication 5 ou 6, dans lequel le circuit amortisseur (20) est intégré dans le convertisseur indirect (11).

8. Circuit d'alimentation en tension selon la revendication 6 ou 7, **caractérisé en ce qu'**une résistance de limitation (22) est disposée en amont de la borne de grille (21) pour la limitation d'un courant de grille.

9. Circuit d'alimentation en tension selon la revendication 8,
**caractérisé en ce qu'**une diode de découplage (23) est connectée entre la résistance de limitation (22) et la borne de grille (21).

10. Circuit d'alimentation en tension selon l'une des revendications précédentes 6 à 9, **caractérisé en ce qu'**au moins un condensateur accumulateur d'énergie (24) est connecté entre une borne de source (25) et la borne de grille (21) du MOSFET à canal N (13).

11. Circuit d'alimentation en tension selon la revendication 10, **caractérisé en ce**
**qu'**une diode de limitation (27) est connectée entre la borne de source (25) et la borne de grille (21) du MOSFET à canal N (13), parallèlement au condensateur accumulateur d'énergie (24), ou
un dispositif de court-circuit (28) est connecté entre la borne de source (25) et la borne de grille (21) pour la mise à l'arrêt du MOSFET à canal N (13).

12. Circuit d'alimentation en tension selon la revendication 11,
**caractérisé en ce que** le dispositif de court-circuit (28) est un optocoupleur (29) pouvant être commuté en particulier par un circuit intégré ou un microcontrôleur.

13. Circuit d'alimentation en tension selon la revendication 12,
**caractérisé en ce que** des états différents du second consommateur (3) peuvent être commutés par le circuit intégré.

14. Circuit d'alimentation en tension selon l'une des revendications précédentes, **caractérisé en ce qu'**une résistance de limitation de courant (30) est connectée entre la borne de grille (21) et le condensateur accumulateur d'énergie (24).

15. Circuit d'alimentation en tension selon l'une des revendications précédentes, **caractérisé en ce qu'**au moins un consommateur supplémentaire (32) est relié au MOSFET à canal N (13) pour la commutation, dans lequel un MOSFET à canal N (13) et un optocoupleur (29) sont éventuellement associés à chacun des consommateurs supplémentaires (32).
